# EUROPEAN PATENT SPECIFICATION

(11) **EP 2 180 506 B1**
(45) Date of publication and mention of the grant of the patent: **10.09.2014**
(21) Application number: 08167650.4
(22) Date of filing: 27.10.2008
(51) Int. Cl.: H01L 25/075

(54) **Light emitting diode device comprising a diode arrangement**
Leuchtdiodenvorrichtung mit einer Diodenanordnung
Dispositif de diode électroluminescente comportant un agencement de diode

(43) Date of publication of application: 28.04.2010
(73) Proprietor: OSRAM Opto Semiconductors GmbH, 93055 Regensburg (DE)
(72) Inventor: Huang, Michelle Kun, 78209 San Antonio (US)
(74) Representative: Epping - Hermann - Fischer

(56) References cited:
- WO-A1-2006/105649
- WO-A1-2007/071397
- WO-A2-2006/077488
- WO-A2-2006/119750
- JP-A- 2002 270 899
- US-A1- 2005 030 744
- US-A1- 2007 223 219
- US-A1- 2007 295 972
- US-A1- 2008 239 476

## Description

For example, the documents WO 2007/071397, WO 2006/077488 and WO 2006/119750 disclose diode arrangements according to the prior art.

The invention refers to a light emitting diode device comprising a diode arrangement for emitting visible light. Devices with light emitting diodes may be used for illumination applications or other purposes. One feature of interest, besides the luminous efficiency of a light source, is its colour rendering index. As familiar to the skilled person, any source of white light has a colour rendering index which can be measured. The CIE standard defines a standardized routine for the measurement of the colour rendering index of a light source. The colour rendering index of a light source theoretically can achieve a maximum value of 100.

In practice, however, a light source even if emitting white light often has a colour rendering index much less than this value of 100. There is a need for providing light sources, in particular for the emission of white light, with a larger colour rendering index.

The invention relates to a light emitting diode device comprising a diode arrangement for emitting visible light, wherein the diode arrangement comprises six light emitting diodes including:
- three first light emitting diodes emitting a first white light,
- two second light emitting diodes emitting non-white light of a first colour and
- one third light emitting diode emitting non-white light of a second colour different from the first colour,
wherein the diode arrangement is emitting a second white light formed by superposition of the light emitted by the first, second and third light emitting diodes.

Such a diode arrangement thus provides a light emitting diode device which produces white light using a group of light emitting diodes forming a diode arrangement, wherein three diodes per se are already emitting white light. Further light emitting diodes emitting non-white, coloured light are provided in addition. Accordingly, a superposition of white light and non-white light yields in a second white light emitted by the entire diode arrangement of the light emitting diode device.

According to one embodiment, the light emitted by the diode arrangement, i.e. the second white light has a higher colour rendering index than the first white light which is emitted by the first light emitting diodes. Accordingly, the second and third light emitting diodes are used for emitting coloured light components having spectral distributions such that the light emitted from all light emitting diodes constituting the diode arrangement has an increased colour rendering index compared to the white light emitted by the first light emitting diodes alone.

According to one embodiment, the second light emitting diodes are emitting green light of a wavelength between 485 and 575 nm, preferably between 505 and 560 nm. In particular, true green light can be emitted, for instance at a wavelength of about 525 nm. According to an embodiment regarding the third light emitting diode, the one third light emitting diode is emitting orange, amber or red light of a wavelength between 590 and 640 nm. The wavelength referred to by these embodiments may be the dominant wavelength, or a the peak wavelength, or any other kind of wavelength.

Accordingly, the one third light emitting diode is emitting one of orange, amber or red light. For instance, orange light of a wavelength of about 605 nm, amber light of a wavelength of about 615 nm or red light of a wavelength of about 630 nm may be used. The second and third light emitting diodes are used to improve the colour rendering in the orange/amber/red and green ranges. Accordingly, for instance peak emissions in particular spectral ranges (like true green for the second light emitting diode) are superposed with a continuous spectrum emitted by the at least one first light emitting diode.

According to a further embodiment, each light emitting diode of the diode arrangement comprises a separate semiconductor chip and all semiconductor chips are mounted on the same support element. The support element may be a carrier plate with circuitry for commonly operating and driving all light emitting diodes of the diode arrangement. However, each light emitting diode of the diode arrangement is provided as an individual, separate piece of die on the support element.

According to another embodiment, the light emitting diodes each are emitting light of a luminous flux of the same order of magnitude. For instance, the numerical range representing this order of magnitude is between 30 and 60 lumen and each single light emitting diode will emit a flux of the same order of magnitude within this range, like 40 lumen for instance. However, brightest diode of the diode array may also emit a luminous flux up to ten times larger than the flux emitted by the diode of the least brightness, in which case the numerical range representing the order of magnitude may range from 20 to 200 lumen, for instance.

The diode arrangement comprises six light emitting diodes, including three first light emitting diodes emitting white light, two second light emitting diodes (emitting light of the first colour) and one third light emitting diode (for emission of light of the second colour). In this embodiment, the relative amount of white light, light of the first colour and light of the second colour are separately weighted relative to one another. For instance, the relative amount of green light emitted by the second diodes is increased relative to the light of the second colour (like orange, amber or red, for instance) emitted by the third diode.

According to the invention, the diode arrangement includes at least two first light emitting diodes emitting white light of two different respective correlated colour temperatures. As familiar to the skilled person, any Planck radiator is emitting light of a particular spectral distribution corresponding to its colour temperature. Even in case of non-ideal radiators, at least a correlated colour temperature can be attributed thereto. In this embodiment, plural diodes generating white light are used as the first light emitting diodes of the diode arrangement, some or all of them having different correlated colour temperature values.

According to one further embodiment, at least one first light emitting diode and/or at least one second light emitting diode comprises a semiconductor chip emitting blue or ultraviolet light and a wavelength conversion material at least partially converting the light emitted by the semiconductor chip to light of a different wavelength or wavelength distribution. The white light of the first light emitting diode is thus generated by at least partial conversion of the blue or ultraviolet light (that is by absorption and re-emission within the wavelength conversion material).

The wavelength conversion material is provided in a chip level coating which for instance covers the front surface of the semiconductor chip of the at least one first light emitting diode.

According to one embodiment the semiconductor chip is a thin-film element. The thin-film element includes a stack of electrooptically active layers for generating visible light. The thin-film element may further comprise a substrate on which the stack of layers has been grown. The substrate may be thinned. However, the substrate may also be removed completely.

According to the invention, the light emitting diode device further comprises an integrated circuit enabling adjustment of a correlated colour temperature of at least one first light-emitting diode. This allows free definition and control of the correlated colour temperature of the first (white light) diode, either by the manufacturer or the customer.

According to a first embodiment, the integrated circuit is compensating tolerances of the colour temperature of a first light emitting diode during operation of the light emitting diode device, thereby maintaining a predetermined colour temperature. The predetermined colour temperature can be predefined by being stored in the integrated circuit during manufacture.

According to a second embodiment, at least one first light emitting diode is tunable with regard to its correlated colour temperature and the integrated circuit comprises a memory element for storing a desired correlated colour temperature value of the at least one first light emitting diode. The desired correlated colour temperature can be input into the memory element by the user of the light emitting diode device. In this way, the colour temperature can be varied within a range of about +/- 20 K, for instance.

According to an embodiment, the light emitting diode device further comprises an optical element covering all light emitting diodes of the diode arrangement, thereby joining light emitted from all light emitting diodes of the diode arrangement to a single beam of light. Though all light emitting diodes are arranged in matrix-like manner at different lateral positions on the support element, their light is joined by means of the optical element to form a single beam of light of improved luminous flux and/or colour rendering index.

Herein below, exemplary embodiments of the invention are described with reference to the Figures.
- FIG. 1: illustrates a first non-inventive embodiment of a light emitting diode device comprising four light emitting diodes, shown in top view,
- FIG. 2: illustrates a cross-sectional view of the embodiment of the light emitting diode device of FIG. 1,
- FIG. 3: illustrates a second embodiment of a light emitting diode device comprising six light emitting diodes, illustrated in top view,
- FIG. 4: illustrates a cross-sectional view of a first and/or second light emitting diode of any of the devices of Figures 1 to 3,
- FIG. 5: illustrates a tabular list of exemplary non-inventive embodiments with four light emitting diodes,
- FIG. 6: illustrates a tabular list of some exemplary embodiments with six light emitting diodes,
- FIG. 7: illustrates the colour rendering index of the light emitting diode devices of FIG. 5,
- FIG. 8: illustrates the luminous flux of the light emitting diode devices of FIG. 5 and 7,
- FIG. 9: illustrates the spectral distribution of the radiant power emitted by a light emitting diode device according to one exemplary embodiment and
- FIG. 10: illustrates the spectral distribution of the radiant power emitted by a light emitting diode device according to another exemplary embodiment.

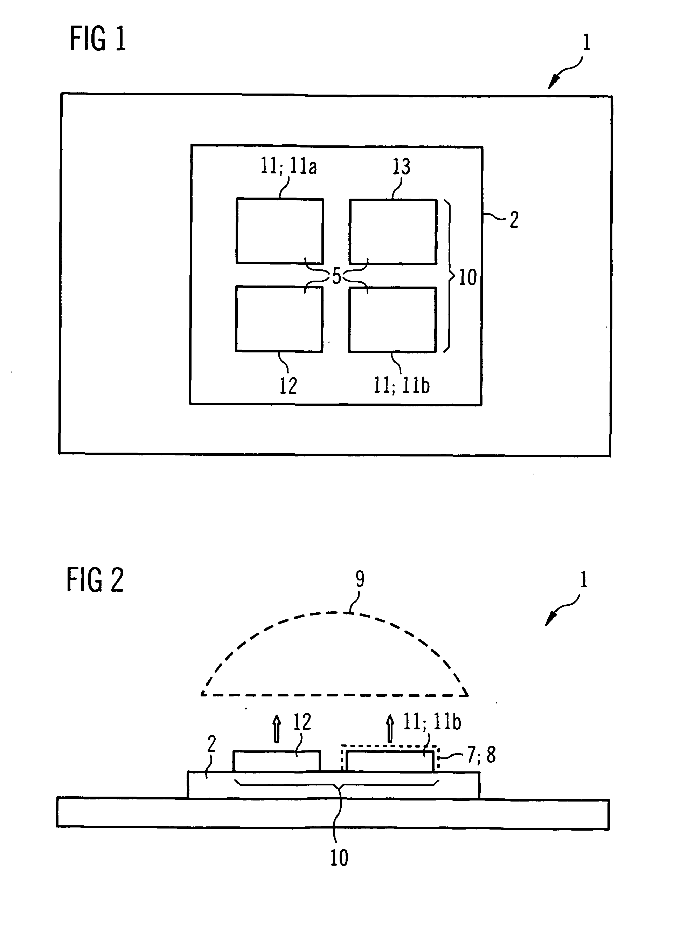

FIG. 1 illustrates a first non-inventive exemplary embodiment of a light emitting diode device in top view. According to FIG. 1, the light emitting diode device 1 comprises four light emitting diodes 11a, 11b, 12, 13 forming a diode arrangement 10. The diode arrangement 10 in particular comprises two first light emitting diodes 11; 11a, 11b both emitting white light. As familiar to the skilled person, any visible light can be represented by chromaticity coordinates Cx and Cy defining the relative ratio between red to total and green to total light components within the CIE-diagram. Around the center of the chromaticity diagram at chromaticity coordinates around Cx = 0,333 and Cy = 0,333, an area corresponding to white light is represented. Light represented by this area causes stimulation of the red, green and blue cones in the human eye to an equal or at least comparable extent, thereby causing the impression of uncoloured, white light.

In contrast thereto, coloured or non-white light may be defined as light directly emitted by light emitting diode, in particular directly by an active zone of a III-V-semiconductor device.

Whereas both first light emitting diodes in FIG. 1 are emitting white light, the second light emitting diode 12 is emitting coloured light of a first colour, like true green (of a wavelength of about 525 nm), for instance. A third light emitting diode is emitting light of another, second colour, like orange, amber or red, for instance. As an example, the wavelength of the light emitted by the third light emitting diode is about 605 nm, 615 nm or 630 nm.

According to FIG. 1, all light emitting diodes, 11a, 11b, 12, 13 comprise a separate semiconductor chip including a stack of electrooptically active layers for generating visible light. The semiconductor chips may further comprise a substrate on which the active layers have been grown. However, the substrate may be thinned or removed completely. Accordingly, the semiconductor chips may be thin-film elements. Anyway, each light emitting diode 11a, 11b, 12, 13 comprises a separate piece of die, all light emitting diodes being arranged in matrix-like manner on a common support element 2. For simplicity of illustration, electrical contacts for the light emitting diode are not illustrated.

The two first light emitting diodes 11a, 11b are emitting white light of the same correlated colour temperature or of different correlated colour temperatures. Two exemplary ranges of the correlated colour temperature are between 7000 and 7300 K and between 5000 and 5500 K.

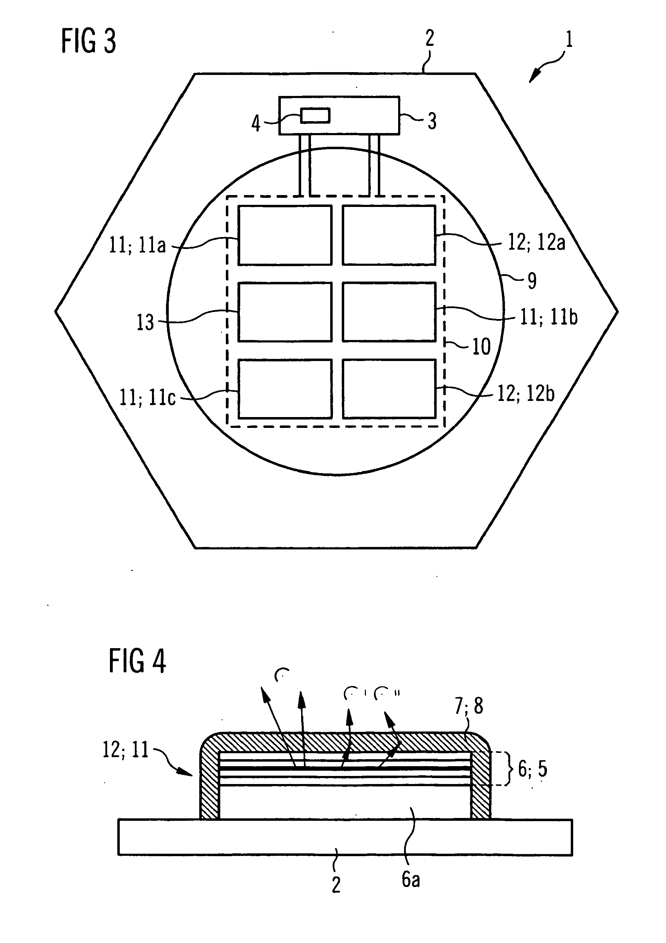

FIG. 2 illustrates a cross-sectional view of the embodiment of FIG. 1. In the cross-sectional view, two light emitting diodes 11b, 12 of the four diodes are illustrated, the main direction of light emission being indicated by the vertical arrows. As schematically indicated in FIG. 2, the first light emitting diode 11b (and 11a of FIG. 1) comprises a wavelength conversion material 7 which is provided, as an example, as a chip level coating 8. Details will be discussed with reference to FIG. 4.

As apparent from FIGs. 1 and 2, the individual light emitting diodes are arranged at different lateral positions on a common support element 2. However, an optional optical element 9 may be provided in order to combine the light emitted from all light emitting diodes to obtain a single beam of light represented by the superposition of the light emitted by each of the light emitting diodes of the diode arrangement.

FIG. 3 illustrates a top view on a second embodiment of the light emitting diode device 1 comprising a diode arrangement with six light emitting diodes. Again, the light emitting diodes of the diode arrangement 10 are arranged in a matrix-like manner on a common support element 2 and an optional optical element 9 combines their emitted light components. According to the embodiment of FIG. 3, the diode arrangement 10 comprises three first light emitting diodes 11; 11a, 11b, 11c emitting the first white light, two second light emitting diodes 12; 12a, 12b emitting coloured light of the first colour and one third light emitting diode 13 emitting the coloured light of the second colour. By providing a plurality of first, second and/or third light emitting diodes 11, 12, 13, the relative composition of the light components (first white light relative to first coloured light and both relative to second coloured light) may be varied.

As indicated in FIG. 3, an optical integrated circuit 3 is provided for enabling adjustment of a correlated colour temperature of the at least one first light emitting diode 11; 11a, 11b, 11c. The integrated circuit may be an application-specific integrated circuit (ASIC), for instance, and may comprise a closed-loop tuning system for tuning the correlated colour temperature, for instance within a range of +/-20 K. In this way, according to the first embodiment, the integrated circuit is compensating, during operation of the light emitting diode device 1, minor tolerances of the correlated colour temperature of some or all of the diodes 11a, 11b, 11c. In particular in case of white light diodes with a low colour temperature tolerance, during production the integrated circuit can be used to preset and predefine the accurate value of the correlated colour temperature for each light emitting diode device. Accordingly, colour temperature fluctuations between a plurality of light emitting diode devices are eliminated. Furthermore, white light emitting diodes with low colour temperature tolerance may be produced for any predefined correlated colour temperature without the need of providing a wavelength conversion material.

As another option, a white light diode which is tunable with regard to its correlated colour temperature may be used for the at least one first light emitting diode 11; 11a, 11b, 11c. In this case the integrated circuit 3 comprises a memory element 4 as illustrated in FIG. 3 for storing and predefining a desired correlated colour temperature of the at least one first light emitting diode. A customer or user of the light emitting diode device will input the desired correlated colour temperature as a target value. During operation, the integrated circuit will control the correlated colour temperature (either of some or all of the first light emitting diodes or of the whole diode arrangement 10) to be in conformity with the target value. The tuning of the correlated colour temperature for instance comprises a measurement of the light emitted by the diode arrangement 10 (or by some or all of the first light emitting diodes 11), for instance by means of an optical sensor measuring light emitted thereby. However, the optical sensor need not form part of the light emitting diode device, the more so as one single measurement of the correlated colour temperature may be sufficient for initial tuning before long-term operation of the light emitting diode device 1. As in FIGs. 1 and 2, in FIG. 3 electrical contacts and further circuitry for contacting and operating the light emitting diodes are not illustrated explicitly.

FIG. 4 illustrates a cross-sectional view of an embodiment with regard to the first and/or second light emitting diodes in FIGs. 1 to 3. In the following, FIG. 4 will be explained with regard to the first light emitting diode 11 for emitting the first white light. The respective first light emitting diode 11 comprises a semiconductor chip 5, like a thin-film element 6, for instance. The semiconductor chip includes a stack of electrooptically active layers for generating visible light. In case of a thin-film element 6, a substrate on which the stack of layers has been grown may be thinned or removed completely. If a (thinned) substrate is present, it may face to the direction of light emission (upwards in FIG. 4).

According to FIG. 4 the semiconductor chip 5 is arranged on a carrier element 6a. The carrier element 6a however is optional and can also be omitted. At the optically active interface surface within the semiconductor chip 5, electromagnetic radiation of a first wavelength distribution is generated and emitted. The first spectral distribution (indicated by λ in FIG. 4) for instance represents ultraviolet light or blue light (with a maximum light intensity at a wavelength between 470 and 485 nm, for instance). According to FIG. 4, the first light emitting diode comprises a wavelength conversion material 7 on the semiconductor chip 5. One option of providing the wavelength conversion material 7 is to apply a chip level coating 8 comprising the wavelength conversion material 7 as illustrated in FIG. 4. The chip level coating 8 is covering at least a front surface of the semiconductor chip 5.

Due to the wavelength conversion material 7, at least a portion of the light emitted by the semiconductor chip 5 is absorbed and re-emitted, thereby emitting other wavelength distributions λ', λ''. Due to the combined emission of wavelength distributions λ, λ' and λ", a broad spectral distribution representing white light is finally emitted by the respective first light emitting diode 11.

Whereas FIG. 4 has been described above with respect to the at least one first light emitting diode 11 for emitting the first white light, alternatively the at least one second light emitting diode 12 (for emitting the non-white light of the first colour, in particular for emitting the green light) may be constructed as illustrated in FIG. 4 and described above with reference to FIG. 4. In this case, in particular green light is re-emitted by the wavelength conversion material 7. Furthermore, both the at least one first light emitting diode 11 as well as the at least one second light emitting diode 12 may be constructed according to FIG. 4.

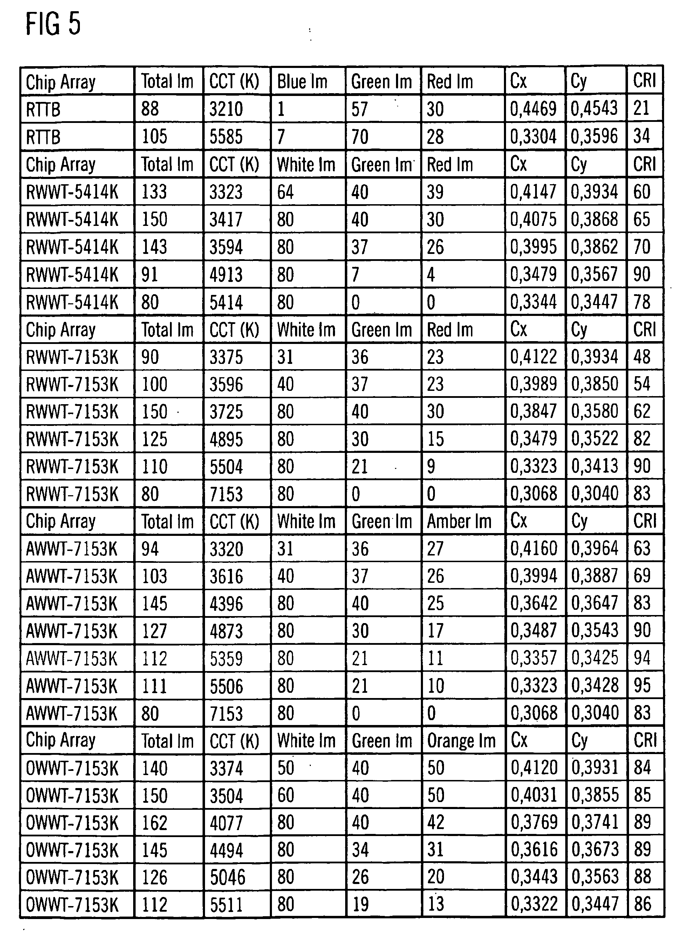

FIG. 5 illustrates, in tabular form, a plurality of non-inventive embodiments with a diode arrangement of four light emitting diodes. In the left column, the composition of the group of light emitting diodes constituting the diode arrangement as well as the colour temperature are indicated. In the second and third line of the table of FIG. 5, two conventional diode arrangements with one diode emitting red light (R), two diodes emitting green light (T) and one diode emitting blue light (B) are listed. In the further columns, the total luminous flux in lumen, the colour temperature, the luminous flux of each respective diode, the chromaticity coordinates Cx and Cy of the light emitted by the respective diode arrangement within the CIE-diagram and, finally, the colour rendering index achieved are listed.

As apparent from the second and third line of the table, conventional three-colour multi-diode arrangements achieve a colour rendering index of about 21 to 34. In the further lines of the table in FIG. 5, the embodiments according to the invention are listed, those embodiments with abbreviations "R", "WW", "T" indicating a diode arrangement with one diode emitting red light (R), two first diodes emitting white light (W) and one diode emitting true green light (T). As an alternative to red light, amber light (A) or orange light (O) may be used as apparent from the last 14 lines in the table of FIG. 5. Furthermore, the correlated colour temperature of the individual white light diodes (that is the first light emitting diodes 11) is indicated. For instance, it may be chosen to be 5414 or 7153 K. In the third column, the correlated colour temperature of the entire diode arrangement (comprising the respective four individual diodes) is indicated. As apparent from FIG. 5, the luminous flux of the individual diodes of the respective diode arrangement is varied in addition.

As apparent from the last column in FIG. 5, by using two white light diodes (WW), one diode of the first colour (true green T) and one diode emitting red (R) or amber (A) or orange (O) light, significantly increased values of the colour rendering index CRI are achieved which may be up to 90, 94 or 95 which is very close to the maximum CRI value of 100 achievable.

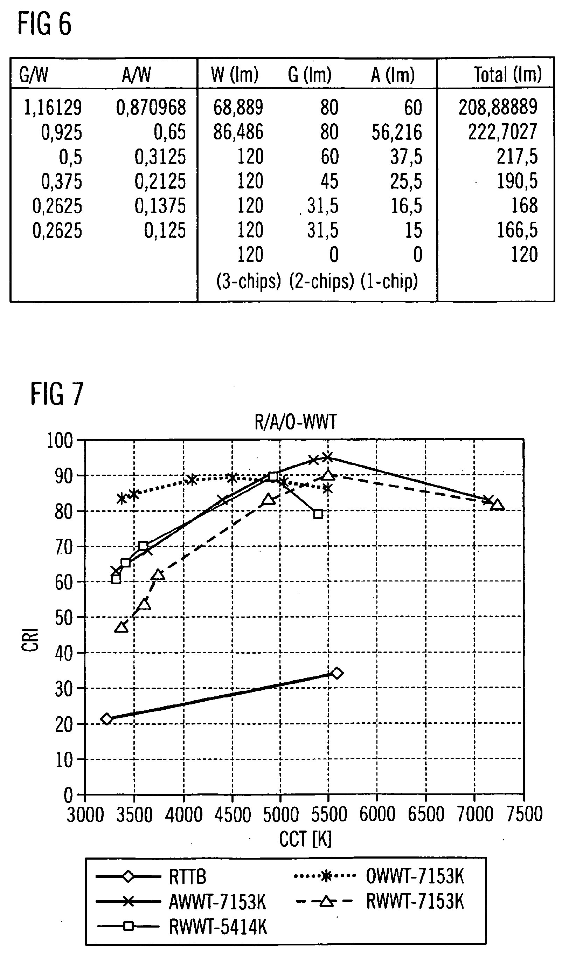

FIG. 6 illustrates exemplary embodiments using six light emitting diodes, among them three respective diodes emitting white light (W), two respective diodes emitting green light (G) and one respective diode emitting amber light (A). The values of the luminous flux (in lumen) are indicated and the relative ratio of green to white light and amber to white light are indicated at the left side in FIG. 6. The total luminous flux of the sixth diode arrangement is indicated at the right side in FIG. 6.

FIG. 7 graphically illustrates the colour rendering index CRI of the two conventional devices and the various embodiments listed in FIG. 5, each comprising four light emitting diodes. The two conventional devices comprising two diodes emitting true green light (T), one diode emitting red light (R) and one diode emitting blue light (B) merely achieve rather low colour rendering index values (of 21 and 34) as apparent from FIG. 7.

In contrast thereto, for the embodiments according to the invention listed in FIG. 5 and comprising two respective diodes emitting white light (W), one diode emitting true green light (T) and one diode emitting red (R), amber (A) or orange (O) light, the colour rendering index CRI is significantly larger compared to the conventional devices. In most embodiments, the colour rendering index is within the range between 75 and 95 which is very close to the optimum colour rendering index value of 100.

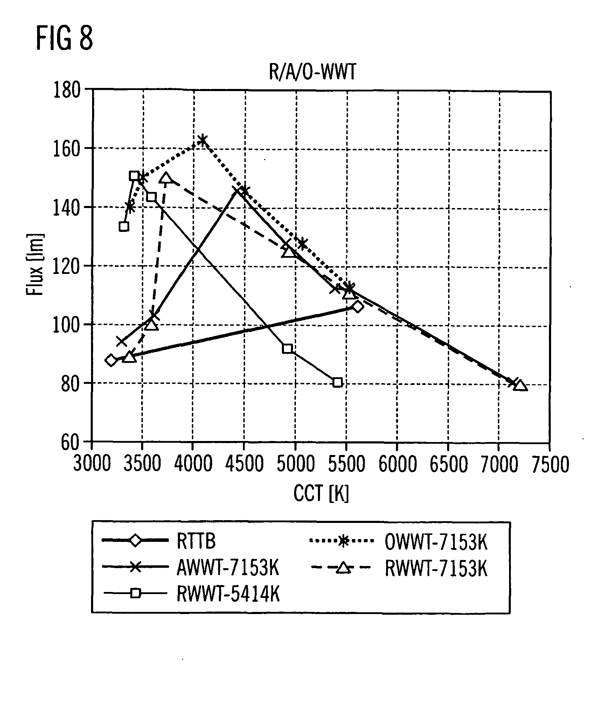

FIG. 8 illustrates the luminous flux of the devices of FIG. 5 and 7. As apparent from FIG. 8, for most of the embodiments from FIG. 5 and 7 also the luminous flux (in lumen) emitted by the respective diode arrangement is larger than the luminous flux obtained when using conventional devices (exclusively comprising diodes emitting non-white, coloured light).

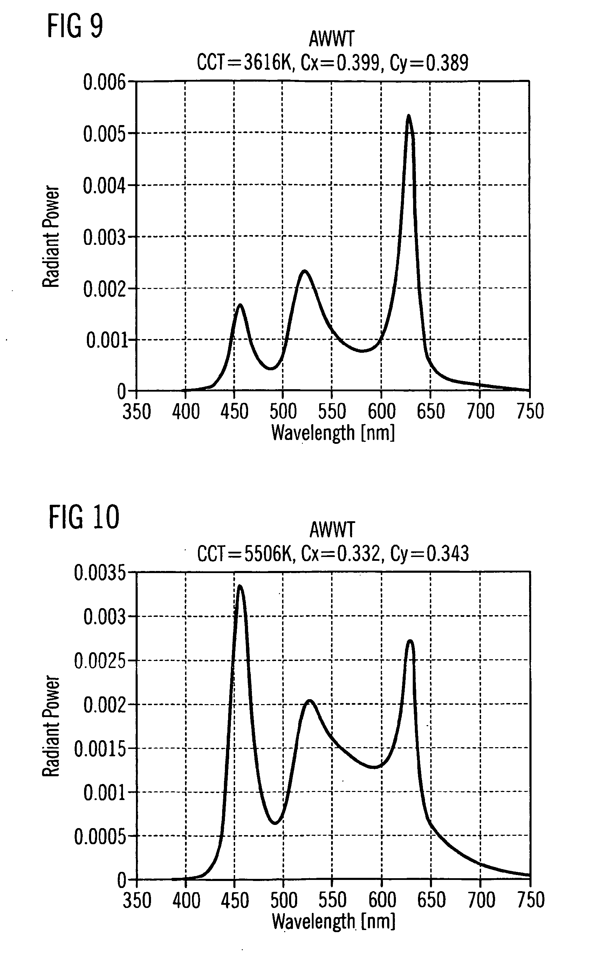

FIGs. 9 and 10 illustrate the spectral distribution of radiant power emitted by light emitting diode devices according to two exemplary embodiments comprising two respective diodes emitting white light (W), one diode emitting true green light (T) and one diode emitting amber light (A). According to both embodiments the diodes emitting white light (W) are constructed as semiconductor chips emitting blue or ultraviolet light and being covered with a chip level coating which comprises a wavelength conversion material. The wavelength conversion material is converting at least a part of the blue or ultraviolet light into light of longer wavelengths and of a broader continuous spectrum. As a result, the spectrum emitted by the four diode arrangement not only comprises peak wavelengths but only comprises a continuous spectral wavelength distribution covering almost the complete range of visible light. In particular, in FIG. 9 the wavelength distribution of the radiant power does not approach to zero in the regions between the peak wavelengths. The benefit of the invention is apparent more clearly in FIG. 10 (corresponding to a four diode arrangement emitting light of 5506 K rather than of 3616 K); according to FIG. 10 the continuous spectrum nearly envelopes the second peak emission around the wavelength of about 525 nm representing green light.

## Claims

1. A light emitting diode device (1) comprising a diode arrangement (10) for emitting visible light, wherein the diode arrangement (10) comprises six light emitting diodes including:
- three first light emitting diodes (11; 11a, 11b, 11c) emitting a first white light,
- two second light emitting diodes (12; 12a, 12b) emitting non-white light of a first colour and
- one third light emitting diode (13) emitting non-white light of a second colour different from the first colour,
wherein the diode arrangement (10) is emitting a second white light formed by superposition of the light emitted by the first (11), second (12) and third light emitting diodes (13),
wherein the diode arrangement (10) includes at least two first light emitting diodes (11; 11a, 11b) emitting white light of different respective correlated colour temperatures (CCT; CCT'),
**characterized in that** the light emitting diode device (1) further comprises an integrated circuit (3) enabling adjustment of a correlated colour temperature of the at least one first light emitting diode (11).

2. The light emitting diode device of claim 1,
**characterized in**
**that** the second white light emitted by the diode arrangement (10) has a larger colour rendering index (CRI) than the first white light emitted by the first light emitting diodes (11).

3. The light emitting diode device of claim 1 or 2,
**characterized in**
**that** the second light emitting diodes (12) are emitting green light of a wavelength between 485 and 575 nm, preferably between 505 and 560 nm.

4. The light emitting diode device of one of claims 1 to 3,
**characterized in**
**that** the third light emitting diode (13) is emitting orange, amber or red light of a wavelength between 590 and 645 nm.

5. The light emitting diode device of one claims 1 to 4,
**characterized in**
**that** each light emitting diode of the diode arrangement (10) comprises a separate semiconductor chip (5) and that all semiconductor chips (5) are mounted on a same support element (2).

6. The light emitting diode device of one of claims 1 to 5,
**characterized in**
**that** the light emitting diodes (11, 12, 13) each are emitting light of a luminous flux of the same order of magnitude for all light emitting diodes (11, 12, 13) of the diode arrangement (10); the luminous flux emitted by each light emitting diode of the diode arrangement (10) preferably being in the range of 30 to 60 lumen.

7. The light emitting diode device of one of claims 1 to 6,
**characterized in**
**that** at least one first light emitting diode (11) and/or at least one second light emitting diode (12) comprises a semiconductor chip (5) emitting blue or ultraviolet light and a wavelength conversion material (7) at least partially converting the light emitted by the semiconductor chip (5) to light of a different wavelength or wavelength distribution.

8. The light emitting diode device of claim 7,
**characterized in**
**that** semiconductor chip (5) is a thin-film element (6).

9. The light emitting diode device of one of claims 1 to 8,
**characterized in**
**that** the integrated circuit (3) is compensating, during operation of a light emitting diode device (1), tolerances of the correlated colour temperature of at least one first light emitting diode (11) to maintain a predetermined correlated colour temperature (CCT).

10. The light emitting diode device of one of claims 1 to 8,
**characterized in**
**that** at least one first light emitting diode (11) is tunable with regard to its correlated colour temperature and that the integrated circuit (3) comprises a memory element (4) for storing a correlated colour temperature value for the at least one first light emitting diode (11) .

11. The light emitting diode device of one of claims 1 to 10,
**characterized in**
**that** the light emitting diode device (1) further comprises an optical element (9) covering all light emitting diodes of the diode arrangement (14), thereby joining light emitted from all light emitting diodes of the diode arrangement (14) to a single beam of light.

## Patentansprüche

1. Leuchtdiodenvorrichtung (1) mit einer Diodenanordnung (10) zum Emittieren von sichtbarem Licht, wobei die Diodenanordnung (10) sechs Leuchtdioden umfasst, aufweisend:
- drei erste Leuchtdioden (11; 11a, 11b, 11c), die ein erstes weißes Licht emittieren,
- zwei zweite Leuchtdioden (12, 12a, 12b), die nicht-weißes Licht einer ersten Farbe emittieren und
- eine dritte Leuchtdiode (13), die nicht-weißes Licht einer zweiten, sich von der ersten Farbe unterscheidenden Farbe emittieren,
wobei die Diodenanordnung (10) ein zweites weißes Licht emittiert, das durch Überlagerung des von den ersten (11), den zweiten (12) und der dritten (13) Leuchtdiode emittierten Lichts gebildet wird,
wobei die Diodenanordnung (10) wenigstens zwei erste Leuchtdioden (11; 11a, 11b) aufweist, die weißes Licht mit verschiedenen, jeweils korrelierenden Farbtemperaturen (CCT; CCT') emittieren,
**dadurch gekennzeichnet, dass** die Leuchtdiodenvorrichtung (1) weiterhin eine integrierte Schaltung (3) aufweist, die ein Einstellen einer korrelierten Farbtemperatur der wenigstens einen ersten Leuchtdiode (11) ermöglicht.

2. Leuchtdiodenvorrichtung nach Anspruch 1,
**dadurch gekennzeichnet, dass**
das zweite weiße, von der Leuchtdiodenanordnung (10) emittierte Licht einen höheren Farbwiedergabeindex (CRI) aufweist als das erste weiße, von den ersten Leuchtdioden (11) emittierte Licht.

3. Leuchtdiodenvorrichtung nach Anspruch 1 oder 2, **dadurch gekennzeichnet, dass**
die zweiten Leuchtdioden (12) grünes Licht mit einer Wellenlänge zwischen 485 und 575 nm, bevorzugt zwischen 505 und 560 nm, emittieren.

4. Leuchtdiodenvorrichtung nach einem der Ansprüche 1 bis 3,
**dadurch gekennzeichnet, dass**
die dritte Leuchtdiode (13) orangefarbiges, bernsteinfarbiges oder rotes Licht mit einer Wellenlänge zwischen 590 und 645 nm emittiert.

5. Leuchtdiodenvorrichtung nach einem der Ansprüche 1 bis 4,
**dadurch gekennzeichnet, dass**
jede Leuchtdiode der Leuchtdiodenanordnung (10) einen separaten Halbleiterchip (5) aufweist und alle Halbleiterchips (5) auf einem gleichen Trägerelement (2) montiert sind.

6. Leuchtdiodenvorrichtung nach einem der Ansprüche 1 bis 5,
**dadurch gekennzeichnet, dass**
die Leuchtdioden (11, 12, 13) jeweils Licht mit einem Lichtstrom in der gleichen Größenordnung für alle Leuchtdioden (11, 12, 13) der Diodenanordnung (10) aufweisen, wobei der von jeder Leuchtdiode der Diodenanordnung (10) emittierte Lichtstrom vorzugsweise im Bereich von 30 bis 60 Lumen liegt.

7. Leuchtdiodenvorrichtung nach einem der Ansprüche 1 bis 6,
**dadurch gekennzeichnet, dass**
wenigstens eine erste Leuchtdiode (11) und/oder wenigstens eine zweite Leuchtdiode (12) einen Halbleiterchip (5) aufweist, der blaues oder ultraviolettes Licht emittiert, und ein Wellenlängenkonversionsmaterial (7), das wenigstens teilweise das vom Halbleiterchip (5) emittierte Licht in Licht mit einer anderen Wellenlänge oder Wellenlängenverteilung umwandelt.

8. Leuchtdiodenvorrichtung nach Anspruch 7,
**dadurch gekennzeichnet, dass**
der Halbleiterchip (5) ein Dünnfilm-Element (6) ist.

9. Leuchtdiodenvorrichtung nach einem der Ansprüche 1 bis 8,
**dadurch gekennzeichnet, dass**
die integrierte Schaltung (3) während des Betriebs einer Leuchtdiodenvorrichtung (1) Toleranzen der korrelierten Farbtemperatur von wenigstens einer ersten Leuchtdiode (11) kompensiert, um eine im Voraus festgelegte korrelierte Farbtemperatur (CCT) aufrechtzuerhalten.

10. Leuchtdiodenvorrichtung nach einem der Ansprüche 1 bis 8,
**dadurch gekennzeichnet, dass**
wenigstens eine erste Leuchtdiode (11) in Bezug auf ihre korrelierte Farbtemperatur einstellbar ist und die integrierte Schaltung (3) ein Speicherelement (4) zum Speichern eines korrelierten Farbtemperaturwerts für die wenigstens eine erste Leuchtdiode (11) aufweist.

11. Leuchtdiodenvorrichtung nach einem der Ansprüche 1 bis 10,
**dadurch gekennzeichnet, dass**
die Leuchtdiodenvorrichtung (1) weiterhin ein optisches Element (9) aufweist, das alle Leuchtdioden der Diodenanordnung (14) abdeckt und dabei das von allen Leuchtdioden der Diodenanordnung (14) emittierte Licht zu einem einzelnen Lichtstrahl verbindet.

## Revendications

1. Dispositif de diode électroluminescente (1) comprenant un agencement de diode (10) permettant d'émettre de la lumière visible, dans lequel l'agencement de diode (10) comprend six diodes électroluminescentes, comprenant :
- trois premières diodes électroluminescentes (11 ; 11a, 11b, 11c) émettant une première lumière blanche ;
- deux secondes diodes électroluminescentes (12 ; 12a, 12b) émettant de la lumière non blanche d'une première couleur ; et
- une troisième diode électroluminescente (13) émettant de la lumière non blanche d'une seconde couleur différente de la première couleur ;
dans lequel l'agencement de diode (10) émet une seconde lumière blanche formée par superposition de la lumière émise par les première (11), seconde (12) et troisième diodes électroluminescentes (13) ;
dans lequel l'agencement de diode (10) comprend au moins deux premières diodes électroluminescentes (11 ; 11a, 11b) émettant de la lumière blanche de différentes températures de couleur (CCT ; CCT') corrélées respectives ;
**caractérisé en ce que** le dispositif de diode électroluminescente (1) comprend en outre un circuit intégré (3) permettant de régler une température de couleur corrélée de l'au moins une première diode électroluminescente (11).

2. Dispositif de diode électroluminescente selon la revendication 1, **caractérisé en ce que** la seconde lumière blanche émise par l'agencement de diode (10) a un indice de rendu de couleur (CRI) plus important que la première lumière blanche émise par les premières diodes électroluminescentes (11).

3. Dispositif de diode électroluminescente selon la revendication 1 ou 2, **caractérisé en ce que** les secondes diodes électroluminescentes (12) émettent de la lumière verte d'une longueur d'onde comprise entre 485 et 575 nm, de préférence entre 505 et 560 nm.

4. Dispositif de diode électroluminescente selon l'une quelconque des revendications 1 à 3, **caractérisé en ce que** la troisième diode électroluminescente (13) émet de la lumière orange, ambrée ou rouge d'une longueur d'onde comprise entre 590 et 645 nm.

5. Dispositif de diode électroluminescente selon l'une quelconque des revendications 1 à 4, **caractérisé en ce que** chaque diode électroluminescente de l'agencement de diode (10) comprend une puce semi-conductrice (5) séparée et que toutes les puces semi-conductrices (5) sont fixées sur un même élément de support (2).

6. Dispositif de diode électroluminescente selon l'une quelconque des revendications 1 à 5, **caractérisé en ce que** les diodes électroluminescentes (11, 12, 13) émettent chacune de la lumière d'un flux lumineux du même ordre de grandeur pour toutes les diodes électroluminescentes (11, 12, 13) de l'agencement de diode (10) ; le flux lumineux émis par chaque diode électroluminescente de l'agencement de diode (10) étant de préférence compris dans la plage allant de 30 à 60 lumens.

7. Dispositif de diode électroluminescente selon l'une quelconque des revendications 1 à 6, **caractérisé en ce qu'**au moins une première diode électroluminescente (11) et/ou au moins une seconde diode électroluminescente (12) comprennent une puce semi-conductrice (5) émettant de la lumière bleue ou ultraviolette et un matériau de conversion de longueur d'onde (7) convertissant au moins en partie la lumière émise par la puce semi-conductrice (5) en lumière de longueur d'onde ou de répartition de longueur d'onde différente.

8. Dispositif de diode électroluminescente selon la revendication 7, **caractérisé en ce que** la puce semi-conductrice (5) est un élément de film fin (6).

9. Dispositif de diode électroluminescente selon l'une quelconque des revendications 1 à 8, **caractérisé en ce que** le circuit intégré (3) compense, en situation de fonctionnement d'un dispositif de diode électroluminescente (1), les tolérances de la température de couleur corrélée d'au moins une première diode électroluminescente (11) pour maintenir une température de couleur (CCT) corrélée prédéterminée.

10. Dispositif de diode électroluminescente selon l'une quelconque des revendications 1 à 8, **caractérisé en ce qu'**au moins une première diode électroluminescente (11) peut être personnalisée quant à sa température de couleur corrélée et que le circuit intégré (3) comprend un élément de mémoire (4) permettant de mémoriser une valeur de température de couleur corrélée pour l'au moins une première diode électroluminescente (11).

11. Dispositif de diode électroluminescente selon l'une quelconque des revendications 1 à 10, **caractérisé en ce que** le dispositif de diode électroluminescente (1) comprend en outre un élément optique (9) recouvrant toutes les diodes électroluminescentes de l'agencement de diode (14), joignant ainsi la lumière émise par toutes les diodes électroluminescentes de l'agencement de diode (14) en un faisceau unique de lumière.
